# EUROPEAN PATENT APPLICATION

(11) **EP 1 513 190 A1**
(43) Date of publication of application: **09.03.2005**
(21) Application number: 04015992.3
(22) Date of filing: 07.07.2004
(51) Int. Cl.: H01L 21/00, B65G 47/00, H01L 21/68

(54) **Positioning device**

(30) Priority: 08.07.2003 JP 2003271969
(71) Applicant: CANON KABUSHIKI KAISHA, Ohta-ku, Tokyo (JP); Canon Precision Inc., Hirosaki-shi, Aomori (JP)
(72) Inventor: Nishimoto, Yoshifumi, Tokyo (JP); Yanagi, Eiichi, Tokyo (JP); Moriya, Akira, Hirosaki-shi, Aomori (JP)
(74) Representative: Leson, Thomas Johannes Alois, Dipl.-Ing.

(57) **Abstract**

A positioning device according to the present invention includes a movable body; a position detection unit detecting a position of the movable body; a first and a second vibratory actuator controlled in accordance with a detection output from the position detection unit; a first transmission mechanism comprising a first gear wheel and a first rack engaging the first gear wheel, the first transmission mechanism transmitting a driving force of the first vibratory actuator to the movable body; and a second transmission mechanism comprising a second gear wheel and a second rack engaging the second gear wheel, the second transmission mechanism transmitting a driving force of the second vibratory actuator to the movable body. An engaging position of the first gear wheel with the first rack is different from an engaging position of the second gear wheel with the second rack.

## Description

The present invention relates to a positioning device used, for example, in a wafer transport apparatus of a semiconductor manufacturing system.

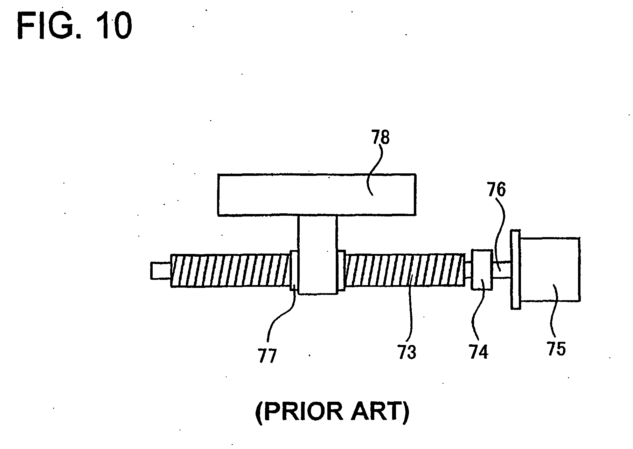

FIG. 10 is a schematic diagram showing an example of a conventional positioning device using a ball screw. In this figure, an output shaft 76 of an electromagnetic motor 75 is connected via a coupling 74 to a ball screw 73. This ball screw 73 receives a driving force from the electromagnetic motor 75, and is thus rotated around the output shaft 76. The rotative motion of the ball screw 73 is converted into a linear motion by a nut 77, and a table 78 attached to this nut 77 is advanced linearly in the shaft direction of the ball screw 73.

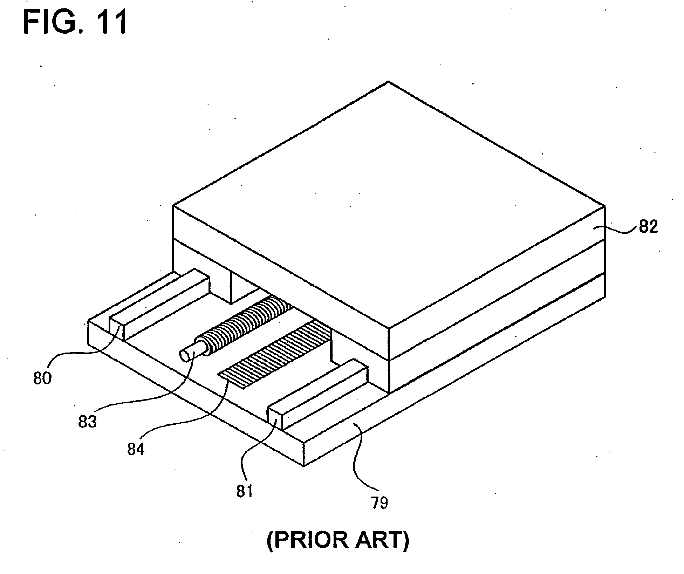

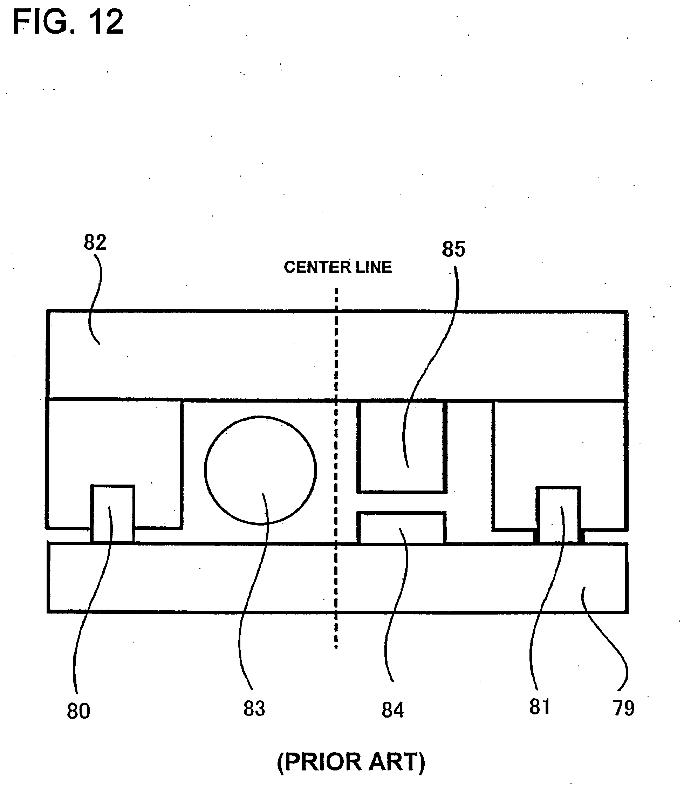

FIG. 11 is a perspective view showing, partially modified, positioning mechanism disclosed in "Application of Linear Systems," 1^{st} ed., page 12, publ. Oct. 16, 2000, by Nikkan Kogyo Shinbunsha, ed. by Akihiro Teramachi, Linear Systems Editorial Committee. FIG. 12 is a cross-sectional view of FIG. 11.

In FIG. 11 and FIG. 12, guide members 80 and 81 are fastened to a base member 79, and when a ball screw 83 receiving a driving force from an electromagnetic motor 75 starts to rotate, its rotating motion is converted into a linear motion by a nut 77. A table 82 attached to the nut 77 is advanced linearly while being guided by guide members 80 and 81.

The position of this linearly advancing table 82 is detected by a later-described position detection unit, and based on the detection result, positioning control of the table 82 is performed. The position detection unit is configured by a linear scale 84 forming a pattern of small stripes on glass substrate, and an optical sensor 85 for optically reading those stripes (see FIG 12).

In this kind of mechanism, the ball screw 83 and the position detection unit (84, 85) are disposed below the table 82, as shown in FIG. 12.

However, in this conventional mechanism, there is a gap between the ball screw and the nut (the portion converting the rotative motion into linear motion), which tends to lead to play due to backlash.

Moreover, conventionally, since an electromagnetic motor is used as a driving source of the positioning device, there was the problem that when the power source of this electromagnetic motor is turned off, the holding torque is lost or becomes small, and the table may be inadvertently moved. In order to counter this problem, it is conceivable to maintain the position by continuing the driving control of the electromagnetic motor (upholding the servo lock), but then the table may vibrate due to the control response or voltage fluctuations, or the electromagnetic motor may heat up due to the continuous application of a current, so that this is not preferable.

Moreover, in the simple mechanism shown in FIGS. 11 and 12, it is desirable that both the ball screw 83 and the position detection unit (84, 85) are placed in the middle of the guide members 80 and 81, above a center line of the table 82 (meaning a line parallel to the moving direction of the table and passing through center of gravity of the table). When the ball screw 83 is not in the center, then a moment acts on the table 82 in the yawing direction, and the table 82 may tilt, lowering the positioning precision, and when the position detection unit is not arranged in the center, then the a position of the table 82 to which a yawing component has been added is detected. However, as becomes clear from FIG. 11, in conventional electrically driven stages, it is not possible to arrange both the ball screw 83 and the position detection unit (84, 85) on the center line of the table 82, so that there was the problem that the positioning precision could not be increased.

In order to attain the above-noted object, a positioning device according to one aspect of the present invention includes a movable body; a position detection unit detecting a position of the movable body; a first and a second vibratory actuator controlled in accordance with a detection output from the position detection unit; a first transmission mechanism comprising a first gear wheel and a first rack engaging the first gear wheel, the first transmission mechanism transmitting a driving force of the first vibratory actuator to the movable body; and a second transmission mechanism comprising a second gear wheel and a second rack engaging the second gear wheel, the second transmission mechanism transmitting a driving force of the second vibratory actuator to the movable body. An engaging position of the first gear wheel with the first rack is different from an engaging position of the second gear wheel with the second rack.

These and further objects and features of the positioning device according to the present invention will become apparent from the following detailed description of preferred embodiments thereof taken in conjunction with the accompanying drawings.
FIG. 1 is a perspective view showing the structure of a positioning device according to Embodiment 1 of the present invention.
FIG. 2 is a graph of the f-N characteristics, illustrating the relation between the driving frequency and the output revolution speed in the vibratory motor according to Embodiment 1.
FIG. 3 is a diagram showing a first example of the relation between rack and gear wheel according to Embodiment 1 of the present invention.
FIG. 4 is a diagram showing a second example of the relation between rack and gear wheel according to Embodiment 1.
FIG. 5 is a perspective view of a structure for pressing a gear wheel against a rack, and a structure for performing a dust prevention process in a positioning device according to Embodiment 2 of the present invention.
FIG. 6 is a diagram of a structure according to Embodiment 2, in which the vibratory motors are stationary and the racks are movable.
FIG. 7 is a diagram of a structure according to Embodiment 2, in which the racks are stationary and the vibratory motors are movable.
FIG. 8 is a perspective view of a positioning device according to Embodiment 3 of the present invention.
FIG. 9 is a plan view of the essential portions of a positioning device according to Embodiment 4 of the present invention.
FIG. 10 is a schematic diagram of a conventional positioning device.
FIG. 11 is a perspective view schematically showing the configuration of a positioning device using a conventional ball screw.
FIG. 12 is a cross-sectional view of the positioning device in FIG. 11.
FIG. 13 is a cross-sectional view of the vibratory motor according to Embodiment 1.

### Embodiment 1

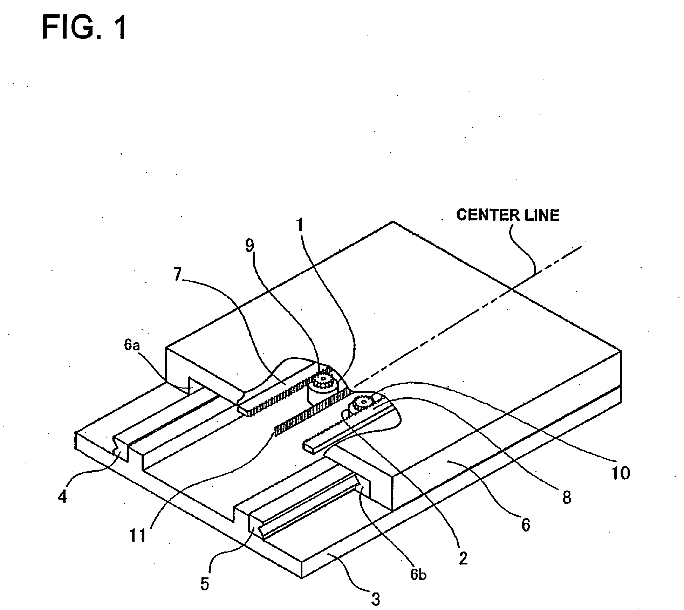

FIG. 1 is a perspective view of a positioning device according to Embodiment 1 of the present invention, in which a portion of the table has been cut away, revealing the internals of the positioning mechanism.

In FIG. 1, reference numerals 1 and 2 denote vibratory motors that excite a vibrator by applying a periodic signal to an electro-mechanical energy conversion element, and serve as vibratory actuators for attaining a rotatory force. Reference numeral 3 denotes a base member, to which the vibratory motors 1 and 2 and guide members 4 and 5 are fixed.

Reference numeral 6 denotes a table 6 (movable body), which advances linearly along the guide members 4 and 5. Reference numerals 7 and 8 denote racks, which are fastened to the table 6. Reference numerals 9 and 10 denote gear wheels, which are fastened to respective output shafts of the vibratory motors 1 and 2. The rack 7 (first rack) engages the gear wheel 9 (first gear wheel), and the rack 8 (second rack) engages the gear wheel 10 (second gear wheel).

The rack 7 and the gear wheel 9 constitute a first transmission mechanism, and the rack 8 and the gear wheel 10 constitute a second transmission mechanism.

It should be noted that a linear system, such as a cross-roller guide or an LM guide (registered trademark), is suitable for the guide members 4 and 5.

Reference numeral 11 denotes a position detection unit for detecting the movement position of the table 6 with respect to the base member 3. This position detection unit 11 is configured, for example, by a linear scale of a thin stripe-shaped pattern formed on a glass substrate and an optical sensor for optically reading the same (FIG. 1 shows only the linear scale).

The position detection unit 11 runs along the center line of the table 6 (the line parallel to the moving direction of the table 6 and passing through center of gravity of the table 6), and has a length dimension encompassing the movement range of the table 6. The racks 7 and 8 and the vibratory motors 1 and 2 are arranged at symmetric positions to the left and right (asymmetric positions are also possible), flanking the position detection unit 11.

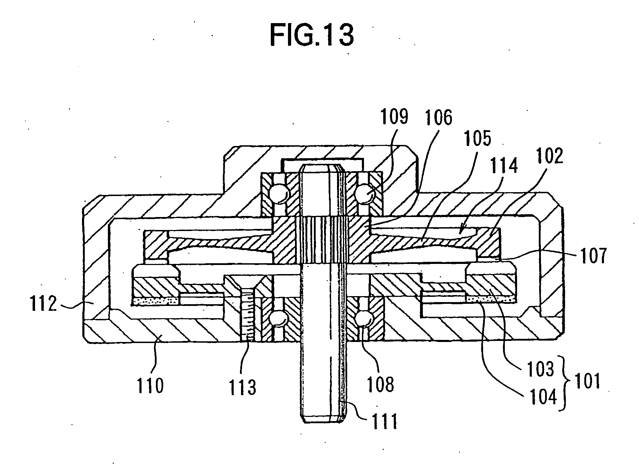

FIG. 13 shows a vibratory motor according to the first embodiment of the present invention.

A vibrating member 101 includes a ring-shaped elastic member 103, and a two-phase piezoelectric element 104 (electro-mechanical energy conversion element) fixed to the bottom surface of the elastic member 103, and is fixed to a base member 110 by attaching the inner side portion of the elastic member 103 to the base member 110 by a screw 113.

A rotary member 114 is formed integrally by a contact ring (contact portion) 102 that contacts the upper surface of the vibrating member 101 (elastic member 103), an annular plate spring (compression portion) 105 which is formed on the inner side of the contact ring 102 and extends in a direction (the right-and-left direction in FIG. 13) crossing the contact direction (the up-and-down direction in FIG. 13) of the contact ring 102 with respect to the vibrating member 101, and an output portion 106 which is formed at the inner side of the plate spring 105 and is spline-coupled to a motor output shaft 111. A slide member 107 is adhered on the surface of the contact ring 102.

The plate spring 105 produces a spring force for bringing the contact ring 102 into press-contact with the vibrating member 101 (via slide member 107) when its inner portion elastically deforms upon being pressed downward in the output axis direction (a direction to approach the vibrating member 101) by an upper bearing 109 of the motor output shaft 111.

In the vibratory motor with this arrangement, frequency signals having different phases are applied to the individual phases of the two-phase piezoelectric element 104 to excite a vibration in the vibrating member 101 (elastic member 103), thus producing a traveling vibration wave on the surface of the vibrating member 101. The contact ring 102 which is in press-contact with the vibrating member 101 via the slide member 107 is rotated by the vibration generated in vibrating member 101, and this rotation force is transmitted to the motor output shaft 111 via the plate spring 105 and the output portion 106, thus obtaining a motor output.

The following is an explanation of the reasons for using the vibratory motors 1 and 2 for the positioning mechanism of the present embodiment.

Firstly, vibratory motors have faster responsiveness than electromagnetic motors. If there is no fast responsiveness, then it is not possible to follow instructions for moving or halting the table 6, and thus to perform position control at the nanometer level, but by using vibratory motors as the driving source, position control at the nanometer level becomes possible.

Secondly, vibratory motors hold the table 6 in the halted position in an uneffective voltage state. In electromagnetic motors or the like, the holding force is lost or becomes small in an uneffective voltage state (when the power source is turned off) so that the table 6 may be moved inadvertently, as was discussed for the conventional example.

Therefore, it is necessary to constantly continue the control (uphold the servo-lock), but when the halting position is maintained with the servo-lock turned on, then the table 6 is in a state in which it vibrates slightly.

Moreover, by keeping on the servo-lock while the table 6 is halted at a predetermined position, there is the risk that the electromagnetic motor heats up. On the other hand, if vibratory motors are used, then the table 6 can be kept at the halting position in an uneffective voltage state, so that there is no need to turn on the servo-lock, and heating as well as vibrations can be avoided. Furthermore, it is not necessary to keep the current source running in order to maintain the halted position, so that it is possible to provide an energy-saving positioning mechanism.

Thirdly, vibratory motors are made of non-magnetic materials. Vibratory motors do not have magnets as structural elements, like electromagnetic motors, so that they do not magnetically affect peripheral devices and also the positioning mechanism is not affected magnetically. Consequently, the positioning mechanism of FIG. 1 can also be applied to electron beam writers or electron microscopes, which are easily affected by magnetism.

Here, a plurality of vibratory motors are used in the present invention. The reason for this is as follows: It is conceivable to use one large vibratory motor, in accordance with the need for a high driving force and speed, but this tends to make the positioning mechanism larger (with bigger wall thicknesses). On the other hand, with a structure having a plurality of small vibratory motors in accordance with necessity, it is possible to fulfill the need for high driving power and speed, while attaining a thinner mechanism.

The following is an explanation of the reasons for disposing the position detection unit 11 along the center line of the table 6 (the line parallel to the moving direction of the table 6 and passing through the center of gravity of the table 6), and disposing the plurality of vibratory motors as well as the gear wheels and the racks constituting an output conversion means for converting the rotative motion into a linear motion flanking the position detection unit 11 to the left and right.

If the position detection unit 11 is disposed on the center line, as in the case of the conventional mechanism shown in FIGS. 11 and 12, then it is not possible to dispose the ball screw on the center line, and a thrust force is imparted on the table from a position that is removed from the center line of the table, which is the movable body, so that the table may be tilted in particular in yawing direction, and the positioning precision cannot be improved.

On the other hand, in the present embodiment, the position detection unit 11 is disposed along the center line of the table 6, as shown in FIG. 1, the vibratory motor 1 and its output conversion means (gear wheel 9 and rack 7) and the vibratory motor 2 and its output conversion means (gear wheel 10 and rack 8) are arranged symmetrically to the left and right of the position detection unit 11.

Thus, it can be prevented that a force in the yawing direction acts on the table 6, and moreover the position detection unit 11 is arranged along the center line, so that no yawing component acts on the detection output, and the positioning precision can be improved.

It should be noted that an example has been given in which the vibratory motors 1 and 2 and their output conversion means are arranged at symmetric positions to the left and right of the position detection unit 11, but if the table 6 does not have a shape with a horizontal symmetry plane, then they do not need to be arranged at symmetric positions.

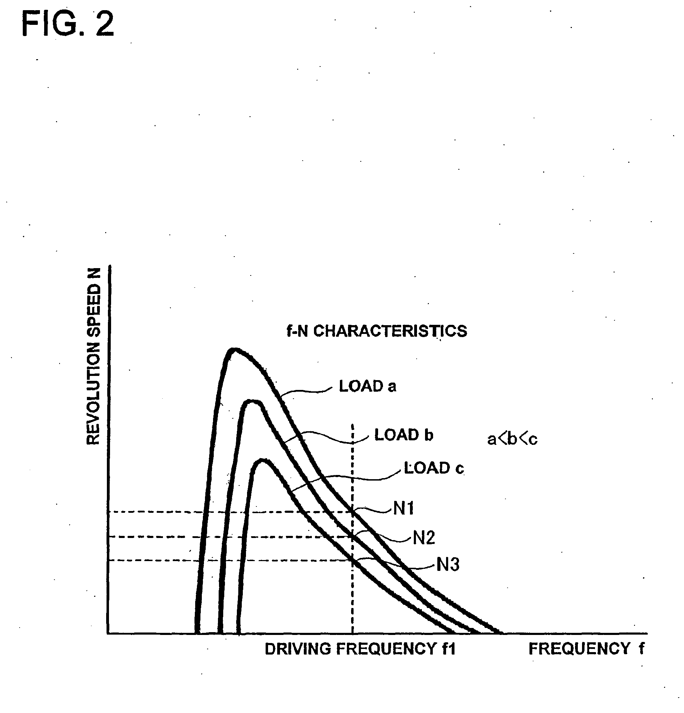

FIG. 2 is a graph of the f-N characteristics, illustrating the relation between the driving frequency f, which is input for driving the vibratory motor, and the output revolution speed N. The curves a, b and c indicate the f-N characteristics for each of three different loads. The loads become larger in the order c, b, a.

As shown in FIG. 2, if the vibratory motors are driven at a given frequency f1, and the load is increased in the order a→b→c, then the revolution speed reduces from N1→N2→N3. Conversely, when the load is reduced, then the revolution speed increases.

Referring to FIGS. 1 and 2, the following is an explanation of the reasons why the play due to backlash can be reduced by using the vibratory motors 1 and 2.

If the driving frequency f1 as shown in FIG. 2 is applied to the vibratory motors 1 and 2 shown in FIG. 1 to move the table 6, then a slightly larger load may act on, for example, vibratory motor 1, due to individual differences of the motors or due to the fact that the loads acting on the plurality of vibratory motors at a given time are not necessarily uniform.

In this case, as the load on the vibratory motor 1 increases, the load of the vibratory motor 2 becomes accordingly smaller, thus increasing the revolution speed of the vibratory motor 2. And thus, when a plurality of vibratory motors is used, such that the load acts on the vibratory motor 2 whose revolution speed is increased, as in the present case, then a driving mechanism can be realized, in which forces are output together such that no backlash occurs, while supporting each other.

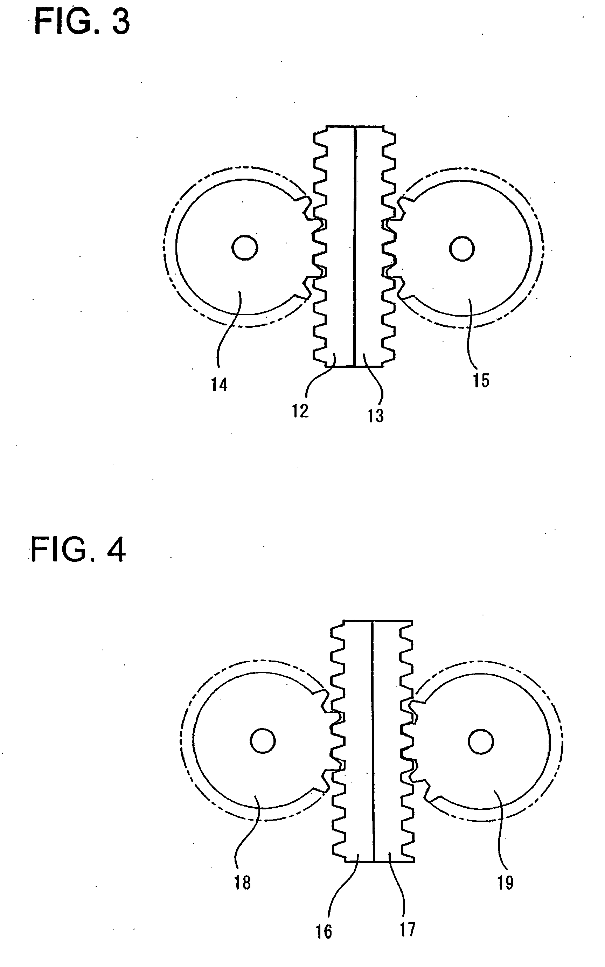

Referring to FIGS. 3 and 4, the following is an explanation of the relation between the racks 7 and 8 and the gear wheels 9 and 10 in FIG. 1. It should be noted that in FIGS. 3 and 4, to facilitate the illustration, the gear wheels and racks illustrated back to back.

FIG. 3 is a diagram showing a first example of the relation between rack and gear wheel, and shows the case that the positions of the teeth of the rack 12 and the rack 13 match each other. With this arrangement, as the gear wheel 14 transmits a force to the rack 12 and the gear wheel 15 transmits a force to the rack 13, there is a synchronicity in the contact between the two sets of gear wheel and rack when transmitting the respective forces, which may cause vibrations or play due to backlash when halting.

FIG. 4 is a diagram showing a second example of the relation between the racks and the gear wheels, and shows the case that the positions of the rack 16 and the rack 17 are offset against one another, or in other words that the contact positions of gear wheel and rack are offset against one another.

That is to say, in FIG. 4, there is a phase difference between the engaging state of the gear wheel 18 and the rack 16 and the engaging state of the gear wheel 19 and the rack 17.

With this phase offset arrangement, when the gear wheel 18 transmits a force to the rack 16 and the gear wheel 19 transmits a force to the rack 17, the synchronicity in the contacts of the two sets of gear wheels and racks can be averted, and play due to backlash when halting can be prevented.

Consequently, by arranging the racks 7 and 8 and the gear wheels 9 and 10 of FIG. 1 as shown in FIG. 4, it is possible to provide a positioning device with which play due to backlash can be prevented.

In order to restrict vibrations occurring between rack and gear wheel, and to improve the precision of the stop position, the surface roughness and the dimensional precision of the rack and the gear wheel are important. Thus, it is desirable that the racks and the gear wheels are subjected to a chemical polishing process in order to improve the surface roughness.

Furthermore, in order to reduce friction between the racks and the gear wheels and to reduce abrasion due to such friction, it is desirable that the racks and the gear wheels are subjected to surface processing such as fluororesin application, or to apply grease, depending on the usage environment.

With Embodiment 1 as described above, the positioning device is made from a combination of a linear position detection unit 11, which is arranged parallel to the movement direction of the table 6 and over the movement range of the table 6 (over a range covering the movement distance), a plurality of vibratory motors 1 and 2 having rapid responsiveness and an uneffective voltage position holding force, arranged to the left and right flanking the position detection unit 11, and an output conversion means made of racks 7 and 8 and gear wheels 9 and 10 fixed to the output shafts of the vibratory motors 1 and 2, which converts the rotative motion of the vibratory motors 1 and 2 into a linear motion to move the table 6.

Thus, by arranging the plurality of vibratory motors and the output conversion means as described above, it is possible to perform the positioning at the nanometer level while preventing play due to backlash. More specifically, a gap between rack and gear wheel occurs even with a tiny difference between the dimensions of the racks and gear wheels, but with the structure of FIG. 1, positioning without backlash can be realized with a simple mechanism even when there is a difference between the dimensions of the racks and gear wheels.

Moreover, energy savings can be achieved due to the holding power of the vibratory motors. Furthermore, it is not necessary to turn on the servo-lock when the vibratory motors are halted, so that vibrations do not occur, and the positioning precision can be improved.

Moreover, by arranging the position detection unit 11 along a line including the center of gravity of the table 6, which is the movable body, and extending along the movement direction of the table 6, positioning is possible without forces acing in yawing direction of the table 6, so that it is possible to improve the positioning precision of the table 6.

Furthermore, by offsetting the phases (positions) of the teeth of the racks 7 and 8 against one another as shown in FIG. 4, it is possible to avert synchronicity in the contacts of the two sets of gear wheels and racks, so that a positioning device can be provided in which there are little vibrations, there is no backlash when halting, and which has a higher precision.

Furthermore, since vibratory motors made of non-magnetic material are used for the driving sources of the table 6, which is the movable body, the positioning device can also be applied, for example, to electron beam writers or electron microscopes, which are easily affected by magnetism. And since it is not affected by magnetic fields, it can be used in strong magnetic fields.

### Embodiment 2

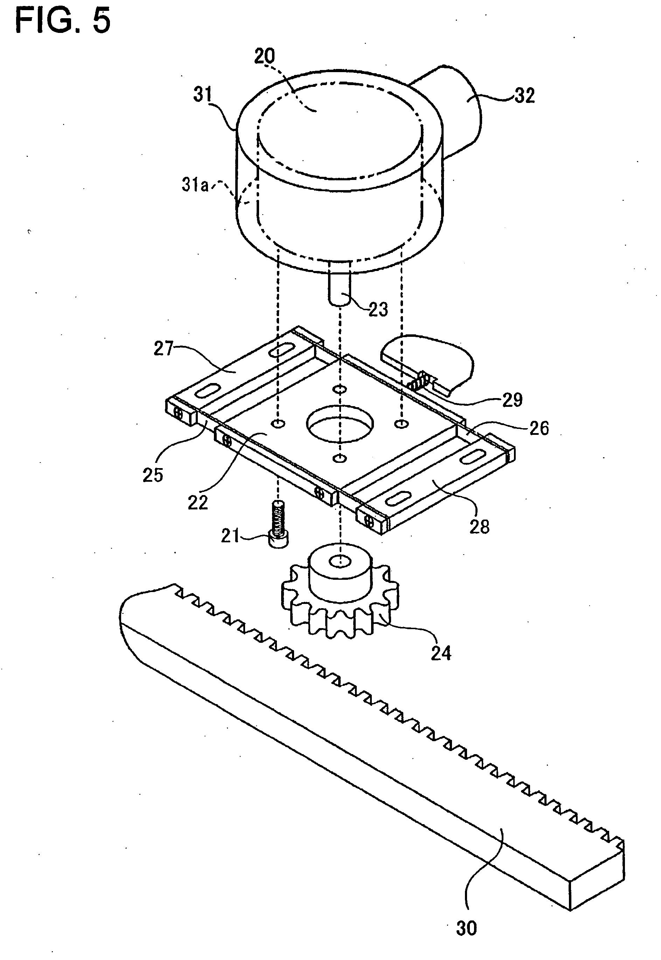

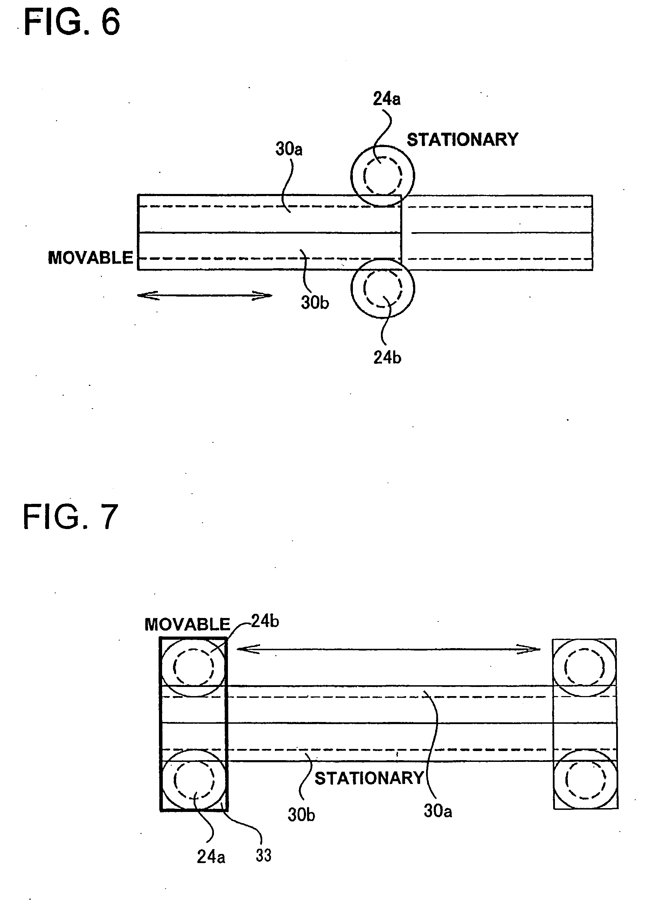

FIG. 5 is a diagram showing a positioning device according to Embodiment 2 of the present invention. FIG. 6 is a diagram showing the structure of the essential portions in FIG. 5.

FIG. 5 shows the structural elements relating to a mechanism for pressing the gear wheel against the rack and a mechanism used for dust prevention, but the aspect that a plurality of vibratory motors, racks and gear wheels are used (see FIG. 6) is the same as in FIG. 1.

First, the mechanism for pressing the gear wheel against the rack is explained.

In FIG. 5, reference numeral 20 denotes a vibratory motor with a gear wheel 24 (24a, 24b) fastened to its output shaft 23. The vibratory motor 20 is fastened by screws 21 to a motor attachment plate 22. Reference numerals 25 and 26 denote parallel springs which are fastened to the motor attachment plate 22. The parallel springs 25 and 26 are fastened to the attachment plates 27 and 28. The attachment plates 27 and 28 are fastened to a base member (not shown in the drawings).

Reference numeral 29 denotes a spring, which presses the gear wheel 24 against the rack 30 (30a, 30b) by pressing against the motor attachment plate 22. An increase of the force with which the gear wheel 24 presses against the rack 30 increases the load, and when the pressing force is set too large, then the stop position precision worsens.

On the other hand, the stop position precision also worsens when the force with which the gear wheel 24 presses against the rack 30 is small. Thus, it is preferable that an optimum value is determined individually for the force with which the gear wheel 24 presses against the rack 30, depending on the conditions.

In an example of a stage combining FIG. 1 with FIG. 5 and a table size of 120 mm square, the best stop position precision was attained when the force at which the gear wheel presses against the rack was 4 to 5 N.

The following is an explanation of the mechanism used for dust prevention.

The positioning device of this embodiment is typically used in locations where a particularly high degree of cleanliness is desired, such as for the wafer transport inside a semiconductor manufacturing system. In movable mechanisms, dust may occur from portions where metals touch or slide against one another, so that a dust prevention process needs to be employed for use in application with stringent cleanliness requirements.

The dust prevention structure in FIG. 5 evacuates foreign matter with a pump (not shown in the drawings) from a vacuum hole portion 32 which is in communication with a gap 31a between a base member 31 and the vibratory motor 20, in order to remove dust from the vibratory motor 20 and the portion where the rack 30 contacts the gear wheel 24. There is also a cooling effect of inhibiting temperature raises with the evacuation.

FIG. 6 is a diagram showing an outline of a positioning device, in which the vibratory motors 20 and the gear wheels 24a and 24b are stationary, and the racks 30 are movable.

If the dust prevention method shown in FIG. 5 is used, and the structure shown in FIG. 6 is adopted, then a simple mechanism is sufficient, with local evacuation at the periphery of the vibratory motor driving the gear wheels 24a and 24b.

FIG. 7 shows an example in which the racks 30 are stationary, and the vibratory motors 20 and the gear wheels 24a and 24b are movable.

As shown in FIG. 7, when the racks 30a and 30b are fixed, and the vibratory motors driving the gear wheels 24a and 24b are attached to the table 33, then the mechanism is such that the table 33 is moved while the interconnection and the cabling for driving the vibratory motors are dragged behind. Thus, the structure of FIG. 7 is used for cases in which a long movement distance is necessary and a strict degree of cleanliness is not necessary.

With this Embodiment 2, a mechanism is provided which is made of the parallel springs 25 and 26 and the spring 29, and which presses the gear wheels 24 against the racks 30, so that the gaps between the racks and the gear wheels are eliminated, and play due to backlash can be prevented more reliably. It should be noted that a structure in which the gear wheels are pressed only with the parallel springs against the rack is also possible.

Moreover, dust prevention is applied at the contact portions of the vibratory motors 20, the racks 30 and the gear wheels 24, so that it becomes possible to use the positioning device with the above-described structure also in locations in which the requirements for the degree of cleanliness are strict. Moreover, by making the vibratory motors 20 stationary and moving the racks 30, it becomes possible to restrict the locations where foreign matter can occur.

### Embodiment 3

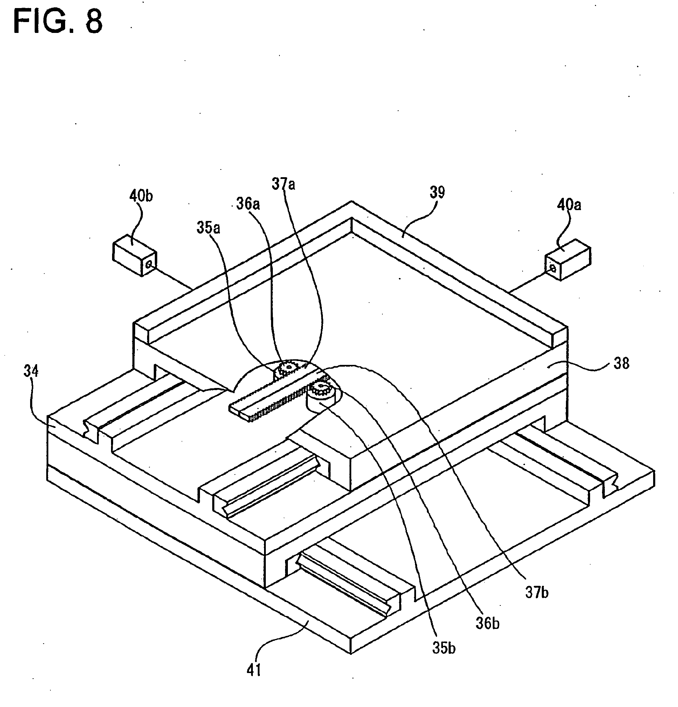

FIG. 8 is a perspective view of a positioning device according to Embodiment 3 of the present invention, in which a portion of the table has been cut away, revealing the internals of the positioning mechanism.

In FIG. 8, reference numeral 34 denotes a base member to which vibratory motors 35a and 35b are fastened. Gear wheels 36a and 36b are fastened to the output shafts of the vibratory motors 35a and 35b. Reference numeral 38 denotes an X-axis table, to which racks 37a and 37b are fastened. The X-axis table 38 moves in accordance with a rotatory operation of the wheel gears 36a and 36b. The base member 34 also serves as a Y-axis table, which is moved, like the X-axis table 38, by racks and gear wheels (not shown in the drawings) in a direction at right angles to the X-axis table 38 with respect to a base member 41.

Reference numeral 39 denotes a mirror fastened to the X-axis table 38. The position of the X-axis table 38 in X-axis direction with respect to the base member 41 is detected by a laser length measuring device 40a, whereas the position of the Y-axis table (34) in Y-axis direction with respect to the base member 41 is detected by a laser length measuring device 40b.

In accordance with Embodiment 3, the present invention can be applied to positioning devices with simple mechanisms in which the table is moved in one direction, as in Embodiment 1 or Embodiment 2, but also to positioning devices in which the table is moved in two directions (i.e. X-Y stages).

That is to say, with such a positioning mechanism, a positioning mechanism becomes possible in which play due to backlash, heating and vibrations can be prevented.

Moreover, with this structure, the thrust force acts on a line that passes through the center of gravity of the movable bodies (X-axis table, Y-axis table), so that there is little tilting of the movable bodies, and there are hardly any problems with the position detection precision when arranging the laser length measuring devices 40a and 40b serving as the position detection units in this manner.

### Embodiment 4

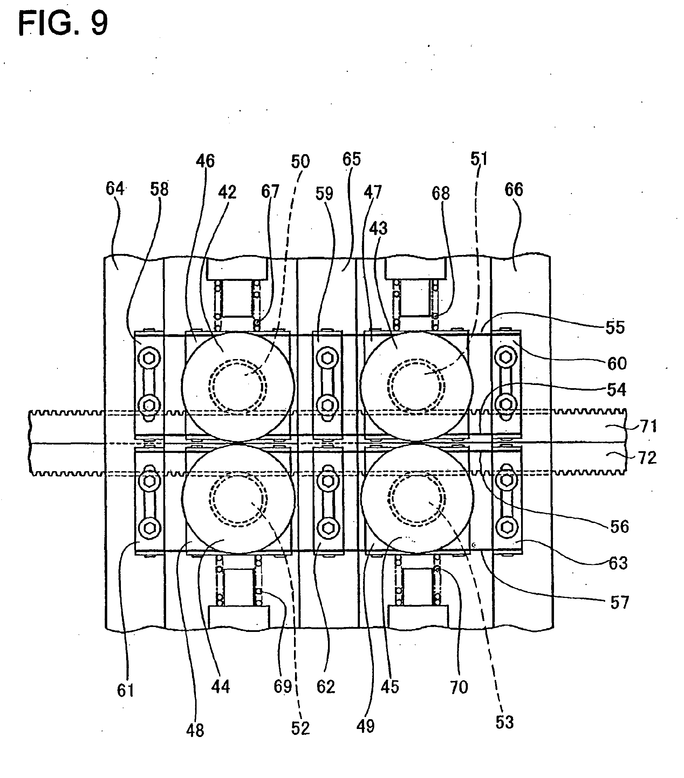

FIG. 9 is a diagram showing the essential portions of a positioning device according to Embodiment 4 of the present invention.

Reference numerals 42 to 45 denote vibratory motors to the output shafts of which gear wheels 50 to 53 are fastened. The vibratory motors 42 to 45 are fastened to motor attachment plates 46 to 49. The motor attachment plates 46 and 47 are fastened to parallel springs 54 and 55, and the motor attachment plates 48 and 49 are fastened to parallel springs 56 and 57. The parallel springs 54 and 55 are fastened to attachment plates 58 to 60, and the parallel springs 56 and 57 are fastened to attachment plates 61 to 63. The attachment plates 58 and 61 are fastened to a base member 64, the attachment plates 59 and 62 are fastened to a base member 65, and the attachment plates 60 and 63 are fastened to a base member 66.

Reference numeral 67 denotes a spring, which presses against the motor attachment plate 46, thus pressing the gear wheel 50 against a rack 71. Similarly, a spring 68 presses against the motor attachment plate 47, thus pressing the gear wheel 51 against the rack 71. Moreover, a spring 69 presses against the motor attachment plate 48, thus pressing the gear wheel 52 against the rack 72, and a spring 70 presses against the motor attachment plate 49, thus pressing the gear wheel 53 against the rack 72.

With this Embodiment 4, a mechanism pressing the gear wheels 42 to 45 against the racks 71 and 72 (made of the parallel springs 54 to 57 and the springs 67 and 70) is provided, and play due to backlash can be prevented even more reliably by eliminating gaps between the racks and the gear wheels.

Moreover, in this structure, four vibratory motors are provided, so that a positioning mechanism is accomplished, which can respond to the needs for large driving power and high-speed movement. That is to say, it is possible to respond to these needs by providing the necessary number of existing vibratory motors, without needing to design new larger vibratory motors, and even when providing four vibratory motors, it is possible to keep the device as flat as the one provided with two vibratory motors shown in FIG. 1.

### Modified Example

In the foregoing Embodiments 1 to 4, examples were illustrated having a plurality of vibratory motors, gear wheels fastened to the output shafts of the vibratory motors, and a plurality of racks engaging the gear wheels, but there is no limitation to this.

For example, it is also possible to configure the racks 37a and 38b in FIG. 8 by forming teeth on both sides of a single rack. Furthermore, also a positioning device including only the rack 71 and the gear wheel 50 and 51 or only the rack 72 and the gear wheel 52 and 53 shown in FIG. 9 is included in the scope of the present invention.

While preferred embodiments have been described, it is to be understood that modification and variation of the present invention may be made without departing from scope of the following claims.

A positioning device according to the present invention includes a movable body; a position detection unit detecting a position of the movable body; a first and a second vibratory actuator controlled in accordance with a detection output from the position detection unit; a first transmission mechanism comprising a first gear wheel and a first rack engaging the first gear wheel, the first transmission mechanism transmitting a driving force of the first vibratory actuator to the movable body; and a second transmission mechanism comprising a second gear wheel and a second rack engaging the second gear wheel, the second transmission mechanism transmitting a driving force of the second vibratory actuator to the movable body. An engaging position of the first gear wheel with the first rack is different from an engaging position of the second gear wheel with the second rack.

## Claims

1. A positioning device, comprising:
a movable body;
a position detection unit detecting a position of the movable body;
a first and a second vibratory actuator controlled in accordance with a detection output from the position detection unit;
a first transmission mechanism comprising a first gear wheel and a first rack engaging the first gear wheel, the first transmission mechanism transmitting a driving force of the first vibratory actuator to the movable body;
a second transmission mechanism comprising a second gear wheel and a second rack engaging the second gear wheel, the second transmission mechanism transmitting a driving force of the second vibratory actuator to the movable body;
wherein an engaging position of the first gear wheel with the first rack is different from an engaging position of the second gear wheel with the second rack.

2. The positioning device according to claim 1,
wherein, in order to provide a phase difference between an engaging state of the first transmission mechanism and an engaging state of the second transmission mechanism, an engaging position of the first gear wheel with the first rack is different from an engaging position of the second gear wheel with the second rack.

3. The positioning device according to claim 1 or 2, further comprising a first and a second pressing mechanism pressing the first and the second gear wheels against the first and the second racks.

4. The positioning device according to any one of claims 1 to 3,
wherein the position detection unit is arranged along a line passing through a center of gravity of the movable body and corresponding to a movement direction of the movable body.

5. The positioning device according to any one of claims 1 to 4, adapted to perform a dust prevention process at the first vibratory actuator and a portion where the first rack contacts the first gear wheel.

6. A positioning device, comprising:
a movable body;
a position detection unit detecting a position of the movable body;
a first and a second vibratory actuator controlled in accordance with a detection output from the position detection unit;
a first transmission mechanism comprising a first gear wheel and a first rack engaging the first gear wheel, the first transmission mechanism transmitting a driving force of the first vibratory actuator to the movable body;
a second transmission mechanism comprising a second gear wheel and a second rack engaging the second gear wheel, the second transmission mechanism transmitting a driving force of the second vibratory actuator to the movable body;
wherein there is a phase difference between an engaging state of the first transmission mechanism and an engaging state of the second transmission mechanism.
